# FASCICULE DE BREVET EUROPEEN

(11) **EP 0 533 785 B1**
(45) Date de publication et mention de la délivrance du brevet: **09.03.1994**
(21) Numéro de dépôt: 91911408.2
(22) Date de dépôt: 14.06.1991
(51) Int. Cl.: G01R 29/10

(54) **DISPOSITIF DE MESURE, EN UNE PLURALITE DE POINTS D'UNE SURFACE DU CHAMP MICRO-ONDE RAYONNE PAR UNE SOURCE**
GERÄT ZUM MESSEN DES VON EINER QUELLE ABGESTRAHLTEN MIKROWELLENFELDES AN EINER VIELZAHL VON PUNKTEN AUF EINER OBERFLÄCHE
DEVICE FOR MEASURING, AT A PLURALITY OF POINTS ON A SURFACE, A MICROWAVE FIELD RADIATED BY A SOURCE

(30) Priorité: 14.06.1990 FR 9007406
(43) Date de publication de la demande: 31.03.1993
(73) Titulaire: SOCIETE D'APPLICATIONS TECHNOLOGIQUES DE L'IMAGERIE MICRO-ONDE, 91952 Les Ulis Cédex (FR)
(72) Inventeur: BOLOMEY, Jean-Charles, F-75013 Paris (FR); PICARD, Dominique, F-92220 Bagneux (FR)
(74) Mandataire: Bloch, Gérard
(86) Numéro de dépôt international: FR9100479
(87) Numéro de publication internationale: WO9119990

(56) Documents cités:
- EP-A- 0 065 455
- EP-A- 0 069 628
- WO-A-88/08529
- FR-A- 2 632 417

## Description

La présente invention a pour objet un dispositif de mesure, en une pluralité de points, du champ micro-onde rayonné par une source, et comprenant :
- en chacun desdits points, au moins une antenne, chargée par au moins une diode,
- des moyens collecteurs du rayonnement micro-onde en provenance de chacune desdites antennes, délivrant un signal micro-onde collecté,
- des moyens générateurs d'un signal basse fréquence,
- des moyens multiplexeurs, disposés entre lesdits moyens générateurs et chacune desdites diodes,
- un circuit d'adressage relié d'une part audit multiplexeur et d'autre part à chacune des diodes, et
- des moyens pour commander lesdits moyens multiplexeurs de façon à ce qu'au moins une desdites diodes soit polarisée par ledit signal basse fréquence, et pour, en réponse audit signal basse fréquence et audit signal micro-onde collecté, engendrer un signal représentatif du champ micro-onde au point où se trouve ladite antenne chargée par ladite diode polarisée.

Un tel dispositif permet, par exemple, lorsque la source est une antenne à caractériser, le relevé, par la méthode connue par l'homme de métier sous le nom de "méthode de diffusion modulée", d'une carte du champ rayonné par l'antenne. Il peut également être utilisé lorsque la source, au lieu d'être une antenne à caractériser, est un objet diffractant un champ micro-onde produit par une antenne auxiliaire dont le diagramme de rayonnement est connu. On peut ainsi contrôler, de façon non destructive, des objets ou produits industriels, ou encore étudier la diffraction par un corps de forme ou de composition complexe.

On connaît, par les demandes françaises publiées sous les numéros 2 614 419 et 2 632 417, des dispositifs du type définis ci-dessus, dans lesquels les points de mesure sont alignés.

Ces dispositifs conviennent donc pour faire, sans déplacement mécanique, des mesures monodimensionnelles du champ micro-onde, c'est-à-dire selon la droite, ou la courbe sur laquelle les antennes sont alignées, par balayage électronique de celles-ci.

Toutefois, ces dispositifs ne conviennent pas pour faire, sans déplacement mécanique, des mesures bidimensionnelles du champ de façon à connaître celui-ci sur une surface.

De plus, ces dispositifs monodimensionnels ne sont pas simplement transposables en dispositifs bidimensionnels à cause de la présence des connexions qui relient chacune des diodes au multiplexeur, et qu'il est nécessaire de rendre invisibles vis à vis du champ micro-onde, afin de ne pas le perturber. Or, s'il est relativement simple de rendre ces connexions invisibles lorsque les antennes sont alignées, comme le montrent les solutions décrites dans les demandes déjà citées N. 2 614 419 et 2 632 417, il est beaucoup plus difficile de le faire dans le cas où les antennes sont réparties sur une surface, sans limiter la bande passante et éventuellement la sensibilité du dispositif.

De plus, lorsque l'on désire mesurer, en chaque point, les composantes du champ selon deux directions de polarisation perpendiculaires, il est nécessaire de disposer, en chacun des points, deux antennes doublets perpendiculaires entre elles, par exemple. Cela complique considérablement le problème précédent lié aux connexions d'amenée du signal basse fréquence vers chacune des antennes.

Par ailleurs, dans le dispositif décrit dans la demande N. 2 614 419, le réseau d'antennes est disposé à proximité d'une antenne collectrice micro-onde, comprenant par exemple un guide d'onde pourvu d'une série de fentes. Il en résulte une relative complexité de réalisation et un risque d'interaction entre l'objet en essai et l'ensemble capteur constitué par le réseau d'antennes et le guide d'onde collecteur.

Ces problèmes ne se posent pas dans le dispositif décrit dans la demande N. 2 632 417, du fait que le réseau linéaire est disposé au foyer d'un réflecteur disposé lui-même à l'écart du trajet du rayonnement provenant de la source. Du fait de la focalisation mise en oeuvre, une telle solution n'est cependant pas transposable à un réseau bidimensionnel d'antennes.

Par ailleurs, on connaît, par le brevet français N. 2 509 064, un dispositif permettant la formation d'une image bidimensionnelle d'un champ micro-onde, et appelé en conséquence "caméra micro-onde". Cette caméra met en oeuvre un réseau bidimensionnel d'antennes doublets, pour lequel le problème lié aux connexions d'amenée du signal de modulation basse fréquence est réglé notamment par l'utilisation, immédiatement derrière le réseau d'antennes, d'une pluralité d'antennes collectrices micro-onde en forme de cornets, empilées les unes sur les autres, et multiplexées. Cette solution, qui met en oeuvre un grand nombre de cornets, et un multiplexage micro-onde, est cependant complexe et d'un coût relativement élevé. De plus, elle ne règle pas le problème de la mesure, sans déplacement mécanique, des composantes du champ selon deux directions de polarisation perpendiculaires, ni celui lié à l'interaction avec l'antenne ou l'objet sous-test.

On connaît également par la demande de brevet européen 0 065 455 un dispositif du type défini ci-dessus dans lequel :
- lesdites antennes sont réparties régulièrement sur une surface, et
- ladite source et lesdits moyens collecteurs sont disposés d'un même côté de ladite surface, et au voisinage l'un de l'autre pour que le trajet depuis ladite source vers ladite surface et le trajet depuis ladite surface vers lesdits moyens collecteurs soient voisins.

Dans un tel dispositif, du fait que les antennes sont réparties sur une surface, il est possible d'effectuer des mesures bidimensionnelles sans mouvement de l'objet en essai relativement au dispositif de mesure, par un simple balayage électronique du réseau d'antennes.

Le circuit d'adressage présente toutefois l'inconvénient d'être visible des moyens collecteurs et par conséquent de largement perturber les mesures, en dehors d'une ou deux bandes passantes étroites, en tout cas inférieure à l'octave. De surcroît la compensation de la perturbation introduite par le circuit d'adressage ne peut être envisagée dans le cas de dipôles croisés nécessaires à la mesure de deux polarisations orthogonales.

L'invention vise à palier les inconvénients précédents.

A cet effet, elle a pour objet un dispositif de ce type, caractérisé par le fait que :
- il est prévu une couche de matériau absorbant le rayonnement micro-onde, dont une face épouse ladite surface, et qui est disposée du côté de ladite surface opposé à celui de ladite source et desdits moyens collecteurs, et,
- ledit circuit d'adressage épouse l'autre face de ladite couche, et est relié à chacune desdites diodes par l'intermédiaire de connexions traversant ladite couche perpendiculairement à ladite surface.

Grâce à la couche d'absorbant derrière laquelle le circuit d'adressage se trouve, vis à vis de la source comme de l'antenne collectrice, ce circuit d'adressage est invisible pour le champ micro-onde. Il peut donc comporter des connexions disposées de la façon la plus pratique pour effectuer l'adressage, sans souci de minimiser les interactions avec le champ micro-onde. En effet, les seules connexions que le champ micro-onde risque de voir sont celles situées au voisinage des antennes. Or, ces connexions traversant la couche d'absorbant, sont perpendiculaires à la surface de cette couche d'absorbant et donc, dans la grande majorité des cas, perpendiculaires au champ micro-onde provenant de la source. Ces connexions ne perturbent donc pratiquement pas ce champ micro-onde. Lorsque l'on désire mesurer les deux composantes du champ selon deux directions de polarisation, et que l'on place, par exemple, deux antennes doublets perpendiculaires en chaque point, l'augmentation de la complexité du circuit d'adressage qui en résulte n'est pas un problème puisque ce circuit d'adressage n'est pas vu par le champ micro-onde, et peut donc être conçu comme un circuit d'adressage ordinaire.

Par ailleurs, vis à vis de l'objet en essai, le réseau d'antennes se comporte principalement comme le panneau d'absorbant, donc sans risque d'interaction notable avec cet objet en essai. On pourrait encore réduire ce risque en couvrant le réseau d'antennes d'une mince couche d'absorbant, au prix d'une légère réduction de la sensibilité.

Enfin, dans le dispositif de l'invention, il n'y a aucun circuit micro-onde à proximité du réseau d'antennes, l'antenne collectrice micro-onde étant disposée au voisinage de la source micro-onde. Une telle disposition simplifie d'une part la réalisation du réseau d'antennes et d'autre part la mise en oeuvre pratique du dispositif de mesure, dans la mesure où les circuits micro-onde peuvent être regroupés dans une même zone, par exemple.

De la même façon, le nombre de fils reliant le dispositif de mesure à l'électronique de commande pourra être réduit de façon très significative par intégration du multiplexeur et du générateur basse-fréquence sur le circuit d'adressage.

Avantageusement, ledit champ micro-onde étant de fréquence pouvant prendre une valeur quelconque dans une gamme, chacune desdites antennes est de dimensions inférieures à la demi-longueur d'onde à la fréquence maximale de ladite gamme.

Dans ce cas, le comportement du réseau est pratiquement indépendant de la valeur de la fréquence, en dehors de celle correspondant à une longueur d'onde voisine du pas de répartition des antennes sur la surface, et le dispositif peut être utilisé pour des applications large bande.

Dans une forme de réalisation, lesdites connexions traversant ladite couche sont des connexions électriques, éventuellement résistives pour réduire les perturbations.

Dans une autre forme de réalisation, lesdites connexions traversant ladite couche sont des connexions optiques et lesdites diodes sont des photodiodes.

Avantageusement, il est prévu, en chacun desdits points, deux antennes, chacune d'entre elle étant sensible à la composante du champ polarisée rectilignement selon une direction déterminée, et les deux antennes sont disposées pour que les deux directions déterminées soient perpendiculaires.

Dans ce cas, il est possible de caractériser complètement le champ, quelles que soient son orientation et sa polarisation, puisque ses deux composantes polarisées rectilignement selon deux directions perpendiculaires sont déterminées.

Avantageusement encore, ladite couche comporte plusieurs sous-couches de matériaux de caractéristiques différentes, pour que ladite couche soit absorbante sur une bande de fréquence.

Avantageusement toujours, ladite source et lesdits moyens collecteurs comprennent une même antenne.

Dans une application particulière, un objet à analyser est disposé entre, d'une part, ladite surface et, d'autre part, ladite source et lesdits moyens collecteurs.

Un tel objet est par exemple une plaque d'un matériau composite quelconque, une planche de bois, ou encore une pièce de tissu dont les inhomogénéités peuvent être mises en évidence à partir des variations du coefficient de transmission du champ micro-onde qui les traverse.

Dans une autre application, ladite surface est une partie de la surface d'une structure illuminée par ladite source.

Dans ce cas, il est possible d'effectuer des relevés de champ sur des structures complexes comme des blindages de bâtiments, des avions, des engins, des satellites, lorsque ceux-ci sont illuminés par un rayonnement micro-onde, pour étudier leur comportement vis à vis d'un radar, ou d'un champ électromagnétique menaçant.

La présente invention sera mieux comprise à l'aide de la description suivante de plusieurs formes de réalisation du dispositif de mesure de l'invention, faite en se référant aux dessins annexés, sur lesquels :
- la fig. 1 représente une vue de dessus du dispositif de l'invention, utilisé pour mesurer le champ rayonné par une antenne,
- la fig. 2 représente une vue de dessus d'une partie du dispositif de la fig. 1, utilisé pour mesurer les caractéristiques de transmission d'une plaque en essai, selon le montage dit "en double transmission",
- la fig. 3 représente une variante de réalisation du réseau d'antennes du dispositif de la fig. 1, et,
- la fig. 4 représente le dispositif de l'invention, utilisé pour mesurer le champ micro-onde sur une portion de la surface d'une structure complexe, lorsque cette surface est illuminée par une source de rayonnement micro-onde.

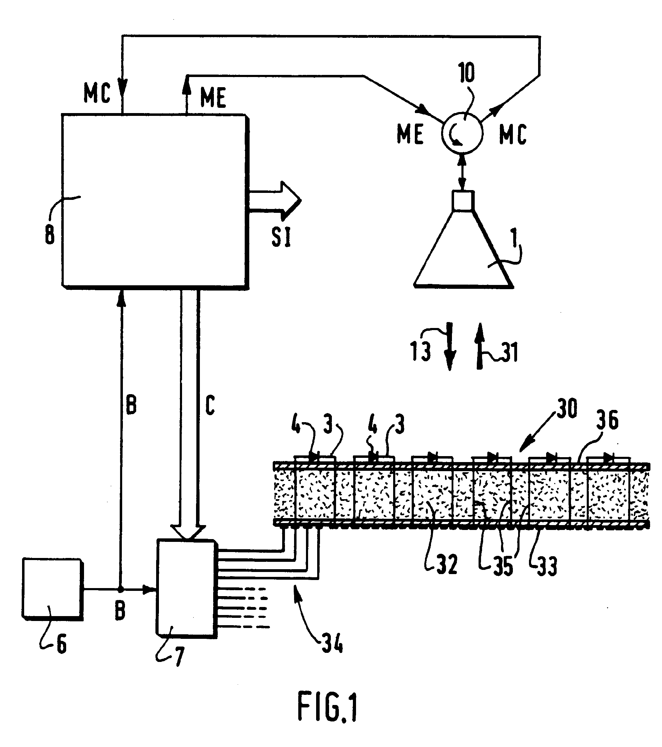

En se référant à la figure 1, un système de mesure du champ proche rayonné par une antenne d'émission 1, ou antenne testée, est maintenant décrit.

En regard de l'antenne testée 1, montée fixe, se trouvent disposées, régulièrement réparties sur une surface 30, une série d'antennes, ici des antennes doublets 3. Comme cela sera mieux compris dans la suite, chacune de ces antennes doublets 3 permet la mesure du champ rayonné par l'antenne testée 1 au point où se trouve cette antenne doublet. Ainsi, on peut dresser la carte du champ proche rayonné sur la surface 30, et en déduire le diagramme de rayonnement en champ lointain de l'antenne testée 1, par exemple. On peut aussi en déduire la carte du champ très proche, dans l'ouverture de l'antenne, notamment pour des applications de diagnostic.

L'antenne 1 est ici alimentée par l'intermédiaire d'un circulateur 10, recevant un signal micro-onde ME, délivré par un générateur micro-onde inclus dans un circuit électronique 8. Le signal micro-onde ME est ici un signal monofréquentiel.

Les antennes doublets 3, arrangées en réseau sur la surface 30 sont ici des antennes de type doublet électrique, c'est-à-dire comprenant chacune deux brins rectilignes égaux et alignés. La cathode d'une diode 4 est reliée à l'un des brins, et son anode est reliée à l'autre brin, de façon à ce que chacune des antennes doublets 3 se trouve chargée en son centre par la diode 4, ici de type PIN.

Les antennes doublets 3 sont ici supportées par un substrat isolant 36 de faible épaisseur. Par exemple, elles sont obtenues par gravure d'une couche métallique appliquée sur le substrat 36, à la manière d'un circuit imprimé.

Une couche 32 de matériau absorbant le rayonnement micro-onde, par exemple une mousse de matériau plastique chargée au carbone, est disposée du côté de la surface 30 opposé à celui où se trouve l'antenne 1, pour qu'une de ses faces épouse le substrat 36. L'épaisseur de la couche 32 est suffisante pour absorber le rayonnement micro-onde à la fréquence du signal ME. De façon connue, elle est comprise entre quelques millimètres et quelques centimètres.

Un circuit d'adressage 33 du réseau de diodes 4 épouse la face de la couche absorbante 32 opposée à celle qui est appliquée contre le substrat 36. Le circuit d'adressage 33 est un circuit imprimé pourvu d'une pluralité de pistes conductrices, chacune d'entre elles étant reliée d'une part, par l'intermédiaire de connexions 34, à une des sorties d'un multiplexeur 7, et d'autre part, par l'intermédiaire de connexions 35, à chacune des diodes 4. Les connexions 35 traversent la couche absorbante 32 perpendiculairement à la surface 30 et aux brins des antennes doublets 3, de façon à ne pas perturber la composante du champ électromagnétique mesurée grâce à chaque antenne doublet 3.

La fréquence du signal micro-onde ME étant susceptible de prendre une valeur quelconque dans une gamme comprise entre une valeur minimale Fₘ et une valeur maximale F_{M}, chacune desdites antennes est de longueur inférieure à la demi-longueur d'onde minimale λₘ/2, c'est-à-dire à la demi-longueur d'onde du rayonnement micro-onde à la fréquence maximale F_{M}.

Le circuit d'adressage 33 est agencé pour que les brins de chaque antenne doublet 3 soit reliés à une des sorties du multiplexeur 7, en nombre égal à celui des antennes doublets 3. Le multiplexeur 7 reçoit sur son unique entrée un signal basse fréquence B issu d'un générateur 6.

Par "signal basse fréquence", on entend ici un signal périodique, carré ou sinusoïdal, dont la gamme de fréquence est considérablement plus basse que la gamme des fréquences habituellement appelées micro-onde. Ainsi, comme on peut admettre que la gamme micro-onde est limitée vers le bas à quelques centaines de Megahertz, le signal B aura en principe une fréquence inférieure à quelques dizaines de Megahertz.

Le rayonnement micro-onde en provenance de chacune des antennes doublets est ici collecté par l'antenne 1 elle-même, le signal micro-onde collecté MC correspondant étant disponible en sortie du circulateur 10.

Le trajet du rayonnement micro-onde depuis l'antenne 1 vers la surface 30, symbolisé par la flèche 13 est donc ici superposé au trajet du rayonnement depuis la surface 30 vers l'antenne 1, symbolisé par la flèche 31.

Un circuit électronique 8, géré à l'aide d'un microprocesseur, est pourvu d'une entrée micro-onde, recevant le signal micro-onde MC, d'une entrée basse fréquence recevant le signal B, d'une sortie micro-onde délivrant le signal micro-onde ME, d'une sortie numérique délivrant un signal C de commande du multiplexeur, et d'une sortie délivrant un signal SI, représentatif du champ micro-onde mesuré et appliqué par exemple à un dispositif d'enregistrement non représenté car connu.

Le dispositif qui vient d'être décrit fonctionne comme suit.

A chaque instant, le microprocesseur du circuit électronique 8 commande le multiplexeur 7 pour que le signal B soit appliqué à une seule des antennes doublets 3, donc à une seule des diodes 4. Ainsi seule cette diode est polarisée, successivement en inverse et en direct, au rythme du signal B.

Simultanément, le rayonnement micro-onde issu de l'antenne testée 1 illumine la surface 30, et le champ diffracté au niveau de chacune des antennes doublets 3 est un échantillon du champ rayonné par l'antenne testée 1 au point où se trouve cette antenne doublet.

L'ensemble des rayonnements en provenance de chacune des antennes doublets 3 est collecté par l'antenne 1 et donne naissance au signal micro-onde collecté MC.

Dans le circuit électronique 8, le signal micro-onde collecté MC subit une détection synchrone micro-onde à l'aide du signal micro-onde ME, puis une seconde détection synchrone basse fréquence à l'aide du signal B. Or, parmi l'ensemble des rayonnements collectés, seul le rayonnement en provenance de l'antenne doublet 3, chargée par la diode polarisée par le signal B, se trouve modulé par ce signal B. De ce fait, le signal MC, après détection micro-onde, puis basse fréquence, n'est représentatif que du champ au point où se trouve l'antenne doublet 3 chargée par la diode 4 polarisée à l'aide du signal B. Le microprocesseur du circuit 8 peut donc commander la polarisation successive de chacune des diodes 4 et élaborer, à partir du signal C qui indique l'emplacement du point de mesure, et du signal résultant de la double détection qui indique la valeur du champ en ce point de mesure, un signal SI de commande du dispositif d'enregistrement.

Ce type de fonctionnement, qui résulte de la mise en oeuvre de la méthode connue par l'homme de métier sous le nom "méthode de diffusion modulée" est décrit dans le brevet américain U.S. 4 552 151.

Le circuit électronique 8 qui comprend donc principalement un générateur micro-onde, un microprocesseur de commande, et un détecteur synchrone micro-onde suivi d'un détecteur synchrone basse fréquence, est à la portée de l'homme de métier et ne sera pas davantage décrit.

Afin de mesurer le champ rayonné selon deux polarisations orthogonales, il est possible de prévoir, en chaque point de la droite 30, de façon non représentée dans un souci de simplicité, deux antennes doublets analogues à l'antenne 3 disposées perpendiculairement l'une par rapport à l'autre. On obtient ainsi deux séries d'antennes doublets. La première série est par exemple disposée verticalement pour être sensible à la composante verticale du champ. Elle est reliée à un premier multiplexeur recevant un premier signal basse fréquence. La deuxième série est disposée horizontalement pour être sensible à la composante horizontale du champ. Elle est reliée à un deuxième multiplexeur recevant un deuxième signal basse fréquence, de fréquence différente de celle du premier signal basse fréquence. Le circuit électronique 8 est agencé pour que le signal micro-onde collecté subisse, après la détection synchrone micro-onde, deux détections synchrones basse fréquence, une à la fréquence du premier signal basse fréquence, l'autre à la fréquence du deuxième signal basse fréquence, ce qui permet la détection simultanée des deux composantes du champ en chaque point.

On pourrait également n'utiliser qu'un seul multiplexeur à un nombre double de voies, en polarisant successivement chacune des diodes des deux séries d'antennes doublets, afin de déterminer, successivement, les deux composantes du champ en un point.

Lorsque l'on travaille à une fréquence peu éloignée de la fréquence minimale Fₘ pour laquelle a été prévue le dispositif, il est possible, surtout si le dispositif a été prévu pour une large gamme de fréquence, de moduler simultanément, à l'aide du signal B, un paquet de plusieurs diodes 4 appartenant à des antennes doublets 3 voisines.

En effet, en général, ces diodes sont disposées selon un pas de λₘ/2 pour obtenir un échantillonnage spatial du champ satisfaisant lorsque l'on travaille à la fréquence maximale F_{M}, et donc à la longueur d'onde minimale λₘ. Par contre, lorsque l'on effectue des mesures à des longueurs d'onde plus élevées, il n'est pas obligatoire d'avoir un pas d'échantillonnage spatial égal à λₘ/2, et, afin de gagner du temps et d'augmenter la sensibilité, le circuit électronique 8 peut être agencé pour que la modulation des diodes 4 se fasse par paquets de taille appropriée.

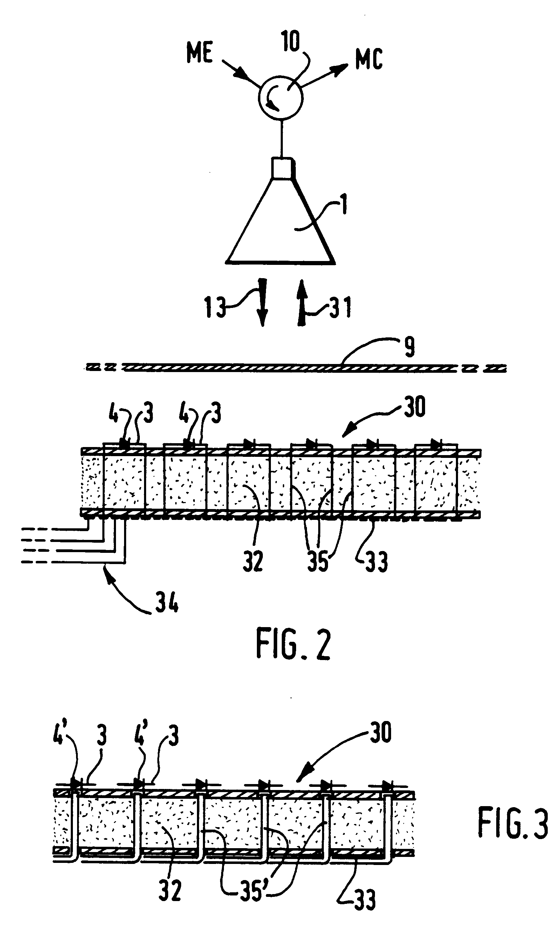

Il n'est pas obligatoire d'utiliser des diodes PIN, et on peut les remplacer par des photodiodes. Dans ce cas, et comme cela est représenté sur la figure 3, les connexions électriques 35 qui traversent la couche absorbante 32 sont remplacées par des connexions optiques, en l'occurrence des fibres optiques 35' dont les extrémités sont disposées en regard de chacune des photodiodes 4'. Dans ce cas la perturbation du champ micro-onde par les connexions d'amenée du signal basse fréquence B à chacune des photodiodes est nulle, quelle que soit l'orientation des fibres 35'.

Dans le cas où la gamme de fréquence du champ micro-onde est relativement étendue, la couche absorbante 32 peut comporter plusieurs sous-couches de matériaux de caractéristiques différentes, afin de procurer un bon coefficient d'absorption dans toute la gamme des fréquences de travail.

Sur la figure 2, le dispositif de mesure est utilisé non plus pour caractériser l'antenne 1, mais une plaque 9 d'un matériau dont l'homogénéité, par exemple, est à contrôler. Dans ce cas, on utilise une antenne 1 de caractéristiques connues, choisie par exemple pour procurer une illumination aussi uniforme que possible de la plaque 9. On travaille ainsi en double transmission, puisque la plaque 9 est traversée une première fois par le rayonnement micro-onde provenant de l'antenne 1, comme le montre la flèche 13, et une deuxième fois par le rayonnement micro-onde en provenance du réseau d'antennes 3 de la surface 30, comme le montre la flèche 31. Toutefois, comme les trajets à l'aller et au retour sont superposés, le champ modulé par le signal B lorsqu'une diode 4 est modulée par ce signal est lié au coefficient de transmission de la plaque 9 à l'endroit où elle est traversée par le rayonnement se dirigeant vers cette diode 4, ou en provenant.

Naturellement, lorsque la plaque 9 est plus grande que le réseau d'antennes 3, ou lorsque l'on contrôle un produit en bande, il est possible d'entraîner la plaque 9, ou la bande, en défilement devant le réseau d'antennes 3.

Dans ce cas, le réseau peut ne comporter qu'une rangée d'antennes disposée perpendiculairement au plan de la figure 2, une image bi-dimensionnelle de l'objet 9 étant obtenue en synchronisant le mouvement de défilement et le balayage des diodes 4.

Dans le cas de la figure 3, la répartition des circuits micro-onde d'un unique côté de l'objet 9 facilite grandement l'implantation du dispositif.

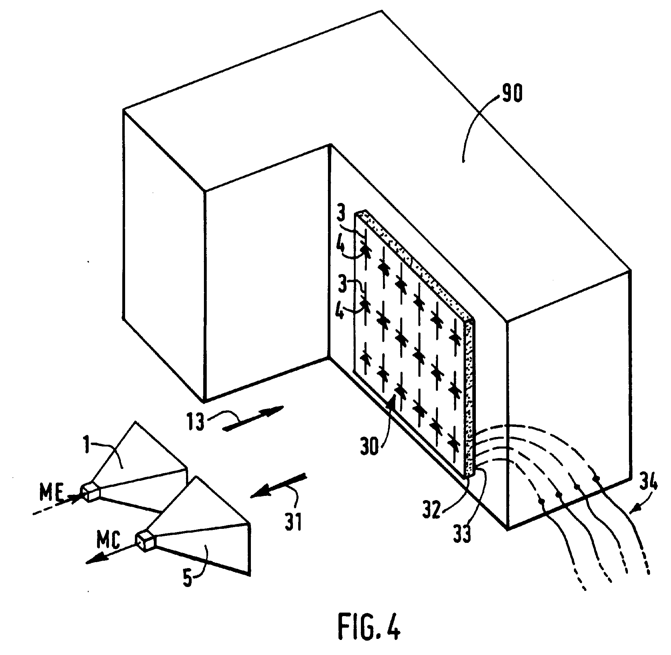

Sur la figure 4, la surface 30 selon laquelle s'étend le réseau d'antennes 3 est une partie de la surface d'une structure complexe 90, ici un blindage métallique. Il est ainsi possible de mesurer le champ sur la surface 30 lorsque la structure 90 est illuminée par la source 1, compte-tenu des réflexions du rayonnement sur les autres parties de la surface.

Sur la figure 4, il est prévu une antenne collectrice 5 distincte de l'antenne émettrice 1, mais disposée du même côté de la surface 30 que cette antenne émettrice 1, et au voisinage de celle-ci pour que le trajet 31 depuis la surface 30 vers l'antenne collectrice 5 soit voisin du trajet 13 depuis l'antenne émettrice vers la surface 30.

Les connexions 34 de raccordement du circuit d'adressage 33 au multiplexeur 7, non représenté sur la figure 4, sont à l'intérieur de la structure 90, pour ne pas être vues par le champ micro-onde.

Dans l'application de la figure 4, la disposition des circuits micro-ondes à l'intérieur d'un unique volume facilite la réalisation d'un dispositif portable, que l'on peut utiliser pour des mesures sur le site.

Il est également possible d'utiliser le réseau d'antennes 3 pour mesurer le champ réfléchi par un objet réfléchissant illuminé par l'antenne 1.

Il est évidemment possible d'utiliser deux antennes distinctes pour l'émission et la réception, comme les antennes 1 et 5 de la figure 4, dans les dispositifs des figures 1 à 3, comme il serait possible d'utiliser un circulateur et une unique antenne, comme le circulateur 10 et l'antenne 1 de la fig. 1, dans le dispositif de la figure 4.

Il n'est pas nécessaire que la surface 30 soit plane, et dans certains cas pratiques, comme l'étude de radômes de forme complexe, la surface peut être une surface gauche quelconque, une demi-sphère, et ainsi de suite.

Il est à noter que la mesure avec une unique antenne risque d'introduire, de façon connue, une ambiguité de phase, dans la mesure où l'on mesure une phase qui est toujours le double de la phase réelle. Ceci n'est pas un problème dans toutes les applications. Pour celles où cette ambiguité de phase risque d'être gênante, il est possible d'en tenir compte en mettant en oeuvre, de façon connue, un algorithme de déroulage de phase.

Il n'est pas obligatoire de disposer, comme cela a été décrit, une diode au centre de chaque antenne doublet. Ainsi, on peut disposer plusieurs diodes par antenne doublet, par exemple deux, l'une au tiers et l'autre aux deux tiers de la longueur totale du doublet.

De même, il n'est pas obligatoire d'utiliser des antennes doublets, et celles-ci peuvent être remplacées par des antennes de tout autre type, chacune étant de dimension faible devant la longueur d'onde minimale λₘ.

Par exemple, on peut utiliser des antennes plaquées ("patch"), des antennes spirales, et des antennes filaires multi-brins.

Il serait également possible, selon un perfectionnement important de l'invention, d'améliorer la modulation dans le cas de diodes. Dans tous les systèmes d'adressage antérieurement décrits, l'élément non linéaire, en l'occurence la diode, est directement modulé par les connections d'adressage lignes-colonnes issues du multiplexeur. Ce montage a l'avantage de la simplicité, mais il en résulte une modulation parasite des diodes non adressées notamment parce qu'elles sont imparfaitement bloquées.

Dans l'agencement décrit ci-dessus, dans lequel le circuit d'adressage est dissimulé par une couche de matériaux absorbants, il devient possible d'éviter les modulations parasites de ce type en adjoignant à chacun des éléments du réseau un circuit logique permettant de ne moduler qu'une seule diode à la fois, toutes les autres étant effectivement bloquées.

A titre d'exemple, on peut utiliser une porte logique en série avec la diode et commandée par les signaux d'adressage lignes-colonnes et ne délivrant le signal de modulation que lorsque ses conditions de validation sont satisfaites.

## Revendications

1. Dispositif de mesure, en une pluralité de points, du champ micro-onde rayonné par une source (1), et comprenant :
- en chacun desdits points, au moins une antenne (3), chargée par au moins une diode (4),
- des moyens collecteurs (1, 10; 5) du rayonnement micro-onde en provenance de chacune desdites antennes (3), délivrant un signal micro-onde collecté (MC),
- des moyens générateurs (6) d'un signal basse fréquence (B),
- des moyens multiplexeurs (7), disposés entre lesdits moyens générateurs (6) et chacune desdites diodes (4),
- un circuit d'adressage relié d'une part audit multiplexeur et d'autre part à chacune des diodes, et
- des moyens (8) pour commander lesdits moyens multiplexeurs (7) de façon à ce qu'au moins une desdites diodes (4) soit polarisée par ledit signal basse fréquence (B), et pour, en réponse audit signal basse fréquence (B) et audit signal micro-onde collecté (MC), engendrer un signal (SI) représentatif du champ micro-onde au point où se trouve ladite antenne (3) chargée par ladite diode polarisée,
dispositif dans lequel :
- lesdites antennes (3) sont réparties régulièrement sur une surface (30), et
- ladite source (1) et lesdits moyens collecteurs (1, 10; 5) sont disposés d'un même côté de ladite surface (30), et au voisinage l'un de l'autre pour que le trajet (93) depuis ladite source (1) vers ladite surface (30) et le trajet (31) depuis ladite surface (30) vers lesdits moyens collecteurs (1, 10; 5) soient voisins,
caractérisé par le fait que :
- il est prévu une couche (32) de matériau absorbant le rayonnement micro-onde, dont une face épouse ladite surface (30), et qui est disposée du côté de ladite surface (30) opposé à celui de ladite source (1) et desdits moyens collecteurs (1, 10; 5), et,
- ledit circuit d'adressage (33) épouse l'autre face de ladite couche (32), et est relié à chacune desdites diodes par l'intermédiaire de connexions (35) traversant ladite couche (32) perpendiculairement à ladite surface (30).

2. Dispositif selon la revendication 1, dans lequel, ledit champ micro-onde étant de fréquence pouvant prendre une valeur quelconque dans une gamme, chacune desdites antennes (3) est de dimensions inférieure à la demi-longueur d'onde à la fréquence maximale de ladite gamme.

3. Dispositif selon l'une des revendications 1 ou 2, dans lequel lesdites connexions (35) traversant ladite couche (32) sont des connexions électriques.

4. Dispositif selon l'une des revendications 1 ou 2, dans lequel lesdites connexions (35') traversant ladite couche (32) sont des connexions optiques et lesdites diodes sont des photodiodes (4').

5. Dispositif selon l'une des revendications 1 à 4, dans lequel il est prévu, en chacun desdits points, deux antennes (3), chacune d'entre elles étant sensible à la composante du champ polarisée rectilignement selon une direction déterminée, et les deux antennes (3) sont disposées pour que les deux directions déterminées soient perpendiculaires.

6. Dispositif selon l'une des revendications 1 à 5, dans lequel ladite couche (32) comporte plusieurs sous-couches de matériaux de caractéristiques différentes, pour que ladite couche soit absorbante sur une bande de fréquence.

7. Dispositif selon l'une des revendications 1 à 6 dans lequel ladite source (1) et lesdits moyens collecteurs (1, 10) comprennent une même antenne (1).

8. Dispositif selon l'une des revendications 1 à 7 dans lequel un objet à analyser (9) est disposé entre, d'une part, ladite surface (30) et, d'autre part, ladite source (1) et lesdits moyens collecteurs (1, 10).

9. Dispositif selon la revendication 8, dans lequel ledit objet à analyser (9) est entraîné en défilement.

10. Dispositif selon l'une des revendications 1 à 7, dans lequel ladite surface (30) est une partie de la surface d'une structure (90) illuminée par ladite source (1).

11. Dispositif selon l'une des revendications 1 à 10, dans léquel lesdits moyens multiplexeurs (7) et lesdits moyens générateurs (6) d'un signal basse fréquence (B) sont intégrés sur ledit circuit d'adressage (33).

## Claims

1. A device for measuring, at a plurality of points, the microwave field radiated by a source (1), and comprising:
-- at each of said points, at least one antenna (3), charged by at least one diode (4),
-- means (1, 10: 5) for collecting the microwave radiation coming from each of said antennas (3), giving off a collected microwave signal (MC),
-- means (6) for generating a low-frequency signal (B),
-- multiplexing means (7) arranged between said generating means (6) and each of said diodes (4),
-- an addressing circuit connected on the one hand to said multiplexer and on the other hand to each of the diodes, and
-- means (8) for controlling the said multiplexer means (7) in such a manner that at least one of said diodes (4) is polarized by said low-frequency signal (B) and in order, in response to said low-frequency signal (B) and to said collected microwave signal (MC), to produce a signal (SI) representative of the microwave field at the point where the said antenna (3) charged by the said polarized diode is located,
in which device:
-- the said antennas (3) are distributed uniformly over a surface (30), and
-- the said source (1) and the said collecting means (1, 10; 5) are arranged on the same side of said surface (30) and in the vicinity of each other so that the path (93) from said source (1) towards said surface (30) and the path (31) from said surface (30) towards said collecting means (1, 10; 5) are close to each other,
characterized by the fact that:
-- a layer (32) of material absorbing the microwave radiation is provided, one face of which fits the shape of said surface (30), and which is arranged on the side of said surface (30) opposite that of said source (1) and of said collector means (1, 10; 5), and
-- the said addressing circuit (33) fits the shape of the other face of said layer (32) and is connected to each of said diodes via connections (35) which pass through said layer (32) perpendicular to said surface (30).

2. A device according to Claim 1, in which, the said microwave field being of a frequency which can assume any value within a range, each of said antennas (3) has dimensions less than the half wavelength at the maximum frequency of said range.

3. A device according to either of Claims 1 and 2, in which the said connections (35) which pass through said layer (32) are electrical connections.

4. A device according to either of Claims 1 and 2, in which the said connections (35') which pass through the said layer (32) are optical connections and the said diodes are photodiodes (4').

5. A device according to any of Claims 1 to 4, in which, at each of said points there are provided two antennas (3), each of them being sensitive to that component of the field which is linearly polarized along a given direction, and the two antennas (3) are arranged so that the two given directions are perpendicular.

6. A device according to any of Claims 1 to 5, in which the said layer (32) comprises several sublayers of materials of different characteristics, so that said layer is absorbent on a frequency band.

7. A device according to any of Claims 1 to 6, in which said source (1) and said collecting means (1, 10) comprise the same antenna (1).

8. A device according to any of Claims 1 to 7 in which an object to be analyzed (9) is arranged between, on the one hand, the said surface (30) and, on the other hand, the said source (1) and the said collecting means (1, 10).

9. A device according to Claim 8, in which the said object to be analyzed (9) is driven past.

10. A device according to any Claims 1 to 7, in which the said surface (30) is a part of the surface of a structure (90) illuminated by said source (1).

11. A device according to any of Claims 1 to 10, in which the said multiplexing means (7) and the said means (6) for the generating of a low-frequency signal (B) are integrated on said addressing circuit (33).

## Patentansprüche

1. Vorrichtung zum Messen des von einer Quelle (1) abgestrahlten Mikrowellenfeldes an einer Vielzahl von Punkten, welche Vorrichtung umfaBt :
- an jedem der Punkte mindestens eine Antenne (3), die durch mindestens eine Diode (4) aufgeladen wird,
- Sammelmittel (1, 10; 5) für die von jeder der Antennen (3) kommende Mikrowellenstrahlung, die ein gesammeltes Mikrowellensignal (MC) liefern,
- Mittel zur Erzeugung (6) eines Niederfrequenzsignales (B),
- Mehrfachkopplungsmittel (7), die zwischen den Erzeugungsmitteln (6) und jeder der Dioden (4) angeordnet sind,
- eine Schaltung zur Adressierung, die einerseits mit dem Mehrfachkoppler und andererseits mit jeder der Dioden verbunden ist, und
- Mittel (8), um diese Mehrfachkopplungsmittel (7) so zu steuern, daß mindestens eine der Dioden (4) durch das Niederfrequenzsignal (B) polarisiert wird, und um in Abhängigkeit von dem Niederfrequenzsignal (B) und dem gesammelten Mikrowellensignal (MC) ein Signal (SI) zu erzeugen, welches das Mikrowellenfeld repräsentiert, das an dem Punkt herrscht, an dem sich die von der polarisierten Diode aufgeladene Antenne (3) befindet,
eine Vorrichtung, bei der:
- die Antennen (3) regelmäßig auf einer Oberfläche (30) verteilt sind, und
- die Quelle (1) und die Sammelmittel (1, 10; 5) auf einer selben Seite der Oberfläche (30) und nebeneinander angeordnet sind, so daß der Weg (93) von der Quelle (1) zur Oberfläche (30) und der Weg (31) von der Oberfläche (30) zu den Sammelmitteln (1, 10; 5) nebeneinander verlaufen,
dadurch gekennzeichnet, daß:
- eine Schicht (32) aus einem die Mikrowellenstrahlung absorbierendem Material vorgesehen ist, deren eine Fläche an der Oberfläche (30) anliegt und die auf derjenigen Seite der Oberfläche (30) angeordnet ist, die der Seite der Quelle (1) und der Sammelmittel (1, 10; 5) entgegengesetzt ist, und
- die Adressierschaltung (33) an der anderen Fläche der Schicht (32) anliegt und mit jeder der Dioden mittels Anschlüssen (35) verbunden ist, welche die Schicht (32) senkrecht zur Oberfläche (30) durchlaufen.

2. Vorrichtung nach Anspruch 1, bei der das Mikrowellenfeld eine Frequenz besitzt, die irgendeinen Wert in einem Bereich annehmen kann, und jede der Antennen (3) Abmessungen besitzt, die kleiner sind als die halbe Wellenlänge bei der maximalen Frequenz dieses Bereichs.

3. Vorrichtung nach einem der Ansprüche 1 oder 2, bei der die Anschlüsse (35), welche die Schicht (32) durchlaufen, elektrische Verbindungen sind.

4. Vorrichtung nach einem der Ansprüche 1 oder 2, bei der die Anschlüsse (35'), welche die Schicht (32) durchlaufen, optische Verbindungen sind und die Dioden Photodioden (4') sind.

5. Vorrichtung nach einem der Ansprüche 1 bis 4, bei der an jedem der Punkte zwei Antennen (3) vorgesehen sind, wobei jede von ihnen für die in einer bestimmten Richtung linear polarisierte Komponente des Feldes empfindlich ist, und die zwei Antennen (3) so angeordnet sind, daß die zwei bestimmten Richtungen senkrecht zueinander sind.

6. Vorrichtung nach einem der Ansprüche 1 bis 5, bei der die Schicht (32) mehrere Unterschichten aus Materialien mit verschiedenen Eigenschaften aufweist, so daß die Schicht über ein Frequenzband absorbiert.

7. Vorrichtung nach einem der Ansprüche 1 bis 6, bei der die Quelle (1) und die Sammelmittel (1, 10) eine selbe Antenne (1) umfassen.

8. Vorrichtung nach einem der Ansprüche 1 bis 7, bei der ein zu untersuchender Gegenstand (9) zwischen einerseits der Oberfläche (30) und andererseits der Quelle (1) und den Sammelmitteln (1, 10) angeordnet wird.

9. Vorrichtung nach Anspruch 8, bei der der zu untersuchende Gegenstand (9) vorbeigeführt wird.

10. Vorrichtung nach einem der Ansprüche 1 bis 7, bei der die Oberfläche (30) ein Teil der Oberfläche einer von der Quelle (1) angestrahlten Struktur (90) ist.

11. Vorrichtung nach einem der Ansprüche 1 bis 10, bei der die Mehrfachkopplungsmittel (7) und die Mittel zur Erzeugung (6) eines Niederfrequenzsignales (B) in die Adressierschaltung (33) integriert sind.
